# EUROPEAN PATENT APPLICATION

(11) **EP 3 133 729 A1**
(43) Date of publication of application: **22.02.2017**
(21) Application number: 14889428.0
(22) Date of filing: 17.04.2014
(51) Int. Cl.: H02N 2/18

(54) **POWER GENERATION SYSTEM**

(71) Applicant: Soundpower Corporation, Kanagawa 252-0816 (JP)
(72) Inventor: HAYAMIZU, Kohei, Mitaka-shi Tokyo 181-0005 (JP)
(74) Representative: Pfenning, Meinig & Partner mbB
(86) International application number: PCT/JP2014/060989
(87) International publication number: WO 2015/159416

(57) **Abstract**

[Problem to be Solved] To provide a power generation system which makes it possible to improve the degree of freedom of installation.

[Solution] A power generation system 1 is provided with: first fluid chambers 10a-10e that contain a fluid; a second fluid chamber 20 that contains the fluid; a communication flow channel 30 that communicates the first fluid chambers 10a-10e and the second fluid chamber 20 with each other; first pistons 40a-40e that are disposed such that the fluid in the first fluid chambers 10a-10e can be pressed; a second piston 50 that is disposed such that the fluid in the second fluid chamber 20 can be pressed; and power generation modules 60a-60e that convert pressing forces of the corresponding first pistons 40 into electricity using piezoelectric elements 63. The power generation elements 63 of the power generation modules 60a-60e generate power in the cases where the second piston 50 is pressed, and the pressing force is transmitted to the first pistons 40a-40e via the fluid, then the piezoelectric elements 63 are indirectly pressed due to the force thus transmitted.

## Description

### [Technical Field]

The present invention relates to a power generation system.

### [Background Art]

Conventionally, as one of technologies of power generation using a piezoelectric element, a system comprising a housing with an upper surface on which a pedestrian can walk and displaceable upon receipt of an external force by the walking and a power generation panel having a piezoelectric element arranged inside the housing and generating power in the cases where the piezoelectric element is pressed by the upper surface of the housing has been proposed (see Patent Literature 1, for example).

### [Citation List]

### [Patent Literature]

Patent Literature 1: Japanese Patent Laid-Open No. 2011-250521

### [Summary of Invention]

### [Technical Problem]

However, in the aforementioned conventional system, since the power generation panel needs to be disposed at a position where the piezoelectric element of the power generation panel can be pressed by the upper surface of the housing as described above, the installation position of the power generation panel is limited. Thus, a degree of freedom of installation is extremely low in the aforementioned conventional system.

The present invention was made in view of the above and has an object to provide a power generation system which makes it possible to improve the degree of freedom of installation.

### [Solution to Problem]

In order to solve the aforementioned problem and to achieve the object, a power generation system described in claim 1 comprises a fluid containing means that contains a fluid, a first piston provided in the fluid containing means and disposed such that the fluid in the fluid containing means can be pressed, a second piston provided in the fluid containing means and disposed such that the fluid in the fluid containing means can be pressed, and a power generation module that converts a pressing force of the first piston into electricity using a power generation element, and the power generation element of the power generation module generates power, in the cases where the second piston is pressed, and the pressing force is transmitted to the first piston via the fluid, then the power generation element is pressed directly or indirectly due to the force thus transmitted.

Moreover, in a power generation system described in claim 2, in the power generation system described in claim 1, the fluid containing means has a first fluid chamber, a second fluid chamber, and a communication flow channel that causes the first fluid chamber and the second fluid chamber to communicate with each other, and the first piston is disposed such that the fluid in the first fluid chamber can be pressed, while the second piston is disposed such that the fluid in the second fluid chamber can be pressed.

Moreover, in a power generation system described in claim 3, in the power generation system described in claim 1 or 2, a total area of a side surface of the second piston that presses the fluid is set larger than the total area of a side surface of the first piston that presses the fluid.

Moreover, in a power generation system described in claim 4, in the power generation system described in claim 2 or 2 and 3, the fluid containing means has a plurality of the first fluid chambers and the communication flow channel that causes each of the plurality of the first fluid chambers and the second fluid chamber to communicate with each other and comprises a plurality of the first pistons provided in each of the plurality of the first fluid chambers and a plurality of the power generation modules corresponding to each of the plurality of the first pistons, and the power generation element in each of the plurality of power generation modules generates power in the cases where the second piston is pressed, and the pressing force is transmitted to each of the plurality of the first pistons via the fluid, then the power generation element is directly or indirectly pressed due to the force thus transmitted.

Moreover, in a power generation system described in claim 5, in the power generation system described in claim 2 or 2 and 3, the fluid containing means has a plurality of the second fluid chambers and the communication flow channel that causes the first fluid chamber and each of the plurality of the second fluid chambers to communicate with each other and comprises a plurality of the second pistons provided in each of the plurality of the second fluid chambers, and the power generation element in the power generation modules generates power in the cases where at least a part of the plurality of the second pistons is pressed, and the pressing force is transmitted to the first piston via the fluid, then the power generation element is directly or indirectly pressed due to the force thus transmitted.

### [Advantageous Effect of the Invention]

According to the power generation system described in claim 1, the power generation element of the power generation module that generates power in the cases where the second piston is pressed, and the pressing force is transmitted to the first piston via the fluid, then the power generation element is directly or indirectly pressed due to the force thus transmitted and thus, even if the first piston and the second piston are installed separately from each other, the force can be transmitted to the power generation module, and the degree of freedom of installation can be improved as compared with the conventional system.

According to the power generation system described in claim 2, since the first piston is disposed such that the fluid in the first fluid chamber can be pressed and the second piston is disposed such that the fluid in the second fluid chamber can be pressed, even if the first fluid chamber and the second fluid chamber are installed separately from each other, the force can be transmitted to the power generation module and thus, the degree of freedom of installation can be further improved.

According to the power generation system described in claim 3, since the total area of the second piston of the side surface that presses the fluid is set larger than the total area of the side surface of the first piston that press the fluid, a stroke of the first piston can be set to a length required for pressing the power generation element of the power generation module while a stroke of the second piston is set to such a length that does not interfere with running of a vehicle, for example, and thus, running performances of the vehicle and power generation efficiency can be maintained. Moreover, if the first pistons are dispersively arranged, a cost increase involved in a size increase of a shape of the power generation element of the power generation module can be avoided as compared with the arrangement of the single first piston, and cost reduction can be made by using a power generation element having a relatively small shape distributed in the market.

According to the power generation system described in claim 4, the power generation element in each of the plurality of the power generation modules generates power in the cases where the second piston is pressed, the pressing force is transmitted to each of the plurality of the first pistons via the fluid, then the power generation element is directly or indirectly pressed due to the force thus transmitted and thus, by increasing the number of installed power generation modules, a power generation amount can be increased.

According to the power generation system described in claim 5, the power generation element in the power generation module generates power in the cases where at least a part of the plurality of the second pistons is pressed, the pressing force is transmitted to the first piston via the fluid, then the power generation element is directly or indirectly pressed due to the force thus transmitted and thus, if the plurality of the second pistons receive an external force from a running vehicle or a walking pedestrian, for example, a frequency of pressing each of the power generation elements of the plurality of power generation modules can be increased as compared with the case of the single second piston and single second fluid chamber, respectively, and thus the power generation amount can be increased.

### [Brief Description of the Drawings]

[Fig. 1] Fig. 1 is a diagram illustrating an outline of a power generation system according to an embodiment 1 of the present invention.
[Fig. 2] Figs. 2 are front diagrams illustrating a deformed state of a piezoelectric element of a power generation module, in which Fig. 2(a) is a view illustrating a state before the piezoelectric element is deformed, and Fig. 2(b) is a view illustrating a state after the piezoelectric element is deformed.
[Fig. 3] Fig. 3 is a diagram illustrating a variation of the power generation module.
[Fig. 4] Fig. 4 is a diagram illustrating an outline of a power generation system according to an embodiment 2.
[Fig. 5] Fig. 5 is a diagram illustrating an outline of a power generation system according to an embodiment 3.
[Fig. 6] Figs. 6 are diagrams illustrating a variation of a second fluid chamber.
[Fig. 7] Figs. 7 are diagrams illustrating an outline of a power generation system according to an embodiment 4, in which Fig. 7(a) is a front view and Fig. 7(b) is a plan view.
[Fig. 8] Fig. 8 is a diagram illustrating a variation of the power generation system according to the embodiment 4.
[Fig. 9] Fig. 9 is a diagram illustrating a variation of the power generation system according to the embodiment 4.
[Fig. 10] Fig. 10 is a diagram illustrating a variation of the power generation system according to the embodiment 4.
[Fig. 11] Fig. 11 is a diagram illustrating a variation of the power generation system according to the embodiment 4.
[Fig. 12] Fig. 12 is a diagram illustrating a variation of the power generation system according to the embodiment 4.

### [Description of Embodiments]

Embodiments of a power generation system according to the present invention will be described below in detail by referring to the attached drawings. However, the present invention is not limited by these embodiments. An installation target of the power generation system according to the embodiments is arbitrary, but in the following explanation, a mode in which the power generation system is installed in a road and its peripheral region so that power generation is performed by using an external force applied from a running vehicle or a walking pedestrian is assumed as an example.

### [Embodiment 1]

First, the power generation system according to an embodiment 1 will be described. This embodiment 1 is a mode comprising a plurality of first fluid chambers, a plurality of first pistons, and a plurality of power generation modules.

### (Configuration)

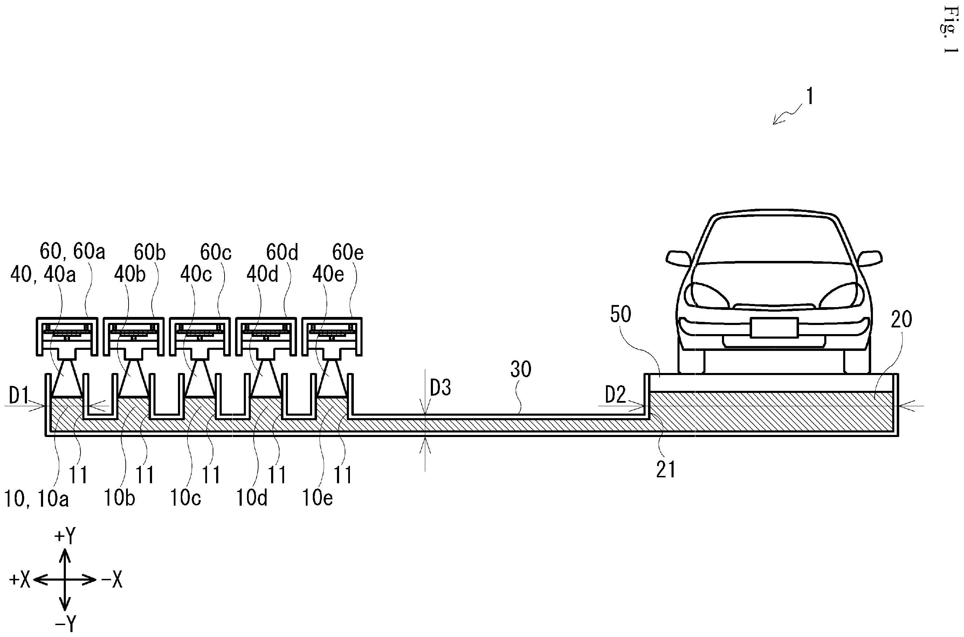

First, configuration of the power generation system according to the embodiment 1 will be described. Fig. 1 is a diagram illustrating an outline of the power generation system according to the embodiment 1 of the present invention. The power generation system 1 is a system for performing power generation by using the external force applied from a running vehicle (four-wheel cars, motorcycles, bicycles and the like, for example). In the following explanation, an X-direction in Fig. 1 refers to a left-right direction (+X-direction is a left direction and -X-direction is a right direction), a Y-direction refers to an up-down direction (+Y-direction is an upward direction and -Y-direction is a downward direction), and a Z-direction refers to a front-rear direction (+Z-direction is a front direction and -Z-direction is a rear direction). This power generation system 1 is configured by comprising first fluid chambers 10a to 10e (when these first fluid chambers 10a to 10e do not have to be discriminated from each other, they are collectively referred to as the "first fluid chamber 10"), a second fluid chamber 20, a communication flow channel 30, first pistons 40a to 40e (when these first pistons 40a to 40e do not have to be discriminated from each other, they are collectively referred to as the "first piston 40"), a second piston 50, power generation modules 60a to 60e (when these power generation modules 60a to 60e do not have to be discriminated from each other, they are collectively referred to as the "power generation module 60").

### (Configuration - First fluid chamber)

The first fluid chambers 10a to 10e are chambers that contain a fluid, respectively. The "fluid" here has fluidity and is a concept comprising a gas such as air, a helium gas and the like, a liquid such as water, oil and the like, and a semi-solid or solid such as a polymer gel and the like, for example. Each of these first fluid chambers 10a to 10e is a substantially columnar hollow body with one side surface (an upper surface or the like, for example) open and is formed of a metal material, a resin material with high hardness, a glass material with high hardness and the like, for example (it is assumed that the same applies to the configuration of the second fluid chamber 20). These first fluid chambers 10a to 10e are juxtaposed/disposed substantially along the left-right direction at a predetermined interval (approximately 1 m, for example) in a peripheral region of a road. A flow channel diameter D1 and a height of each of the first fluid chambers 10a to 10e are set to substantially the same size or height, respectively, for example.

Moreover, in a lower surface of each of the first fluid chambers 10a to 10e, a first communication port 11 is provided. The first communication port 11 is an opening for causing each of the first fluid chambers 10a to 10e and the communication flow channel 30 to communicate with each other.

### (Configuration - Second fluid chamber)

The second fluid chamber 20 is a chamber that contains a fluid. This second fluid chamber 20 is disposed on a road surface of the road separated from each of the first fluid chambers 10a to 10e with an interval therebetween. A flow channel diameter D2 of this second fluid chamber 20 is set to a size larger than the flow channel diameter D1 of each of the first fluid chambers 10a to 10e and an outer diameter of the second piston 50 to a size larger than a width of a vehicle, for example.

Moreover, in a lower surface of the second fluid chamber 20, a second communication port 21 is provided. The second communication port 21 is an opening for causing the second fluid chamber 20 and the communication flow channel 30 to communicate with each other.

### (Configuration - Communication flow channel)

The communication flow channel 30 is a flow channel that causes each of the first fluid chambers 10a to 10e and the second fluid chamber 20 to communicate with each other. This communication flow channel 30 is formed of a substantially tubular body and is made to communicate with each of the first fluid chambers 10a to 10e through the first communication port 11 of each of the first fluid chambers 10a to 10e and is made to communicate with the second fluid chamber 20 through the second communication port 21 of the second fluid chamber 20.

A shape of this communication flow channel 30 is set as follows. First, a flow channel diameter D3 of this communication flow channel 30 is set substantially the same as the flow channel diameter D1 of each of the first fluid chambers 10a to 10e, for example (or may be set smaller or larger than the flow channel diameter D1 of each of the first fluid chambers 10a to 10e). A length of the communication flow channel 30 is set to a length that can keep a loss of a force transmitted to the fluid contained in each of the first fluid chambers 10a to 10e within a predetermined value, for example (specifically, within approximately 10% of the external force applied from the vehicle or the like). The first fluid chamber 10, the second fluid chamber 20, and the communication flow channel 30 correspond to "fluid containing means" in the claim.

### (Configuration - First piston)

The first pistons 40a to 40e are for pressing the corresponding power generation modules 60. Each of these first pistons 40a to 40e is formed of a substantially columnar body with an outer diameter of an upper surface smaller than an outer diameter of a lower surface and is formed of a metal material, a resin material with high hardness, a glass material with high hardness and the like, for example. These first pistons 40a to 40e are disposed such that the fluid contained in the corresponding first fluid chambers 10 can be pressed and specifically, they are disposed such that the lower surfaces of the first pistons 40a to 40e are brought into contact with the fluid contained in the corresponding first fluid chambers 10.

Here, a shape of each of the first pistons 40a to 40e is set as follows. First, the outer diameter of the lower surface of each of the first pistons 40a to 40e has substantially the same size, respectively, for example, and is set to substantially the same size as the flow channel diameter D1 of the corresponding first fluid chamber 10 (or the size smaller than the flow channel diameter D1). The outer diameter of the lower surface of each of the first pistons 40a to 40e is substantially the same size, respectively, for example, and is set to the size smaller than a lower surface of a pressing portion 64 of the power generation module 60 which will be described later (or the size substantially the same or larger than the lower surface of the pressing portion 64). A thickness of each of the first pistons 40a to 40e has substantially the same thickness, respectively, for example, and is set to a thickness that can transmit the pressing force to the corresponding power generation module 60 without a loss due to deformation of the first piston 40 or the like when each of the first pistons 40a to 40e presses the corresponding power generation module 60.

### (Configuration - Second piston)

The second piston 50 is a piston for receiving the external force from the vehicle. This second piston 50 is a substantially columnar body formed of a metal material, a resin material with high hardness, a glass material with high hardness and the like, for example. The second piston 50 is disposed such that the fluid contained in the second fluid chamber 20 can be pressed and specifically, disposed such that the lower surface of the second piston 50 is brought into contact with the fluid contained in the second fluid chamber 20.

Here, a shape of the second piston 50 is set as follows. First, regarding an outer diameter of the second piston 50, the outer diameter of the second piston 50 is set larger than the width of the vehicle and to substantially the same size as the flow channel diameter D2 of the second fluid chamber 20 (or the size smaller than the flow channel diameter D2), for example. A thickness of the second piston 50 is set to a thickness that can keep a deflection amount to such a degree that does not interfere with running of the vehicle (approximately 1 mm, for example) when the external force from the vehicle is applied to the second piston 50.

Regarding a relation between a planar shape of each of the first pistons 40a to 40e and a planar shape of the second piston 50, it is set to a shape that can reduce a cost while running performances of the vehicle and power generation efficiency are maintained, respectively, for example. Specifically, a total area of a side surface of the second piston 50 that presses the fluid (or more specifically, a total area of the lower surface of the second piston 50) is set larger than a total area of side surfaces of the first pistons 40a to 40e that press the fluid (more specifically, the total area of the lower surfaces of the first pistons 40a to 40e). By means of setting to such a shape, a stroke of each of the first pistons 40a to 40e can be set to a length required to press a piezoelectric element 63 of the power generation module 60 which will be described later while a stroke of the second piston 50 is set to such a degree that does not interfere with running of the vehicle due to Pascal's principle and thus, running performances of the vehicle and power generation efficiency can be maintained. Moreover, since the plurality of the first pistons 40 are dispersively arranged, a cost increase involved in a size increase of a shape of the piezoelectric element 63 of the power generation module 60 which will be described later can be avoided and the cost reduction can be made by using the piezoelectric element 63 having a relatively small shape distributed in the market as compared with the arrangement of the single first piston 40.

### (Configuration - Power generation module)

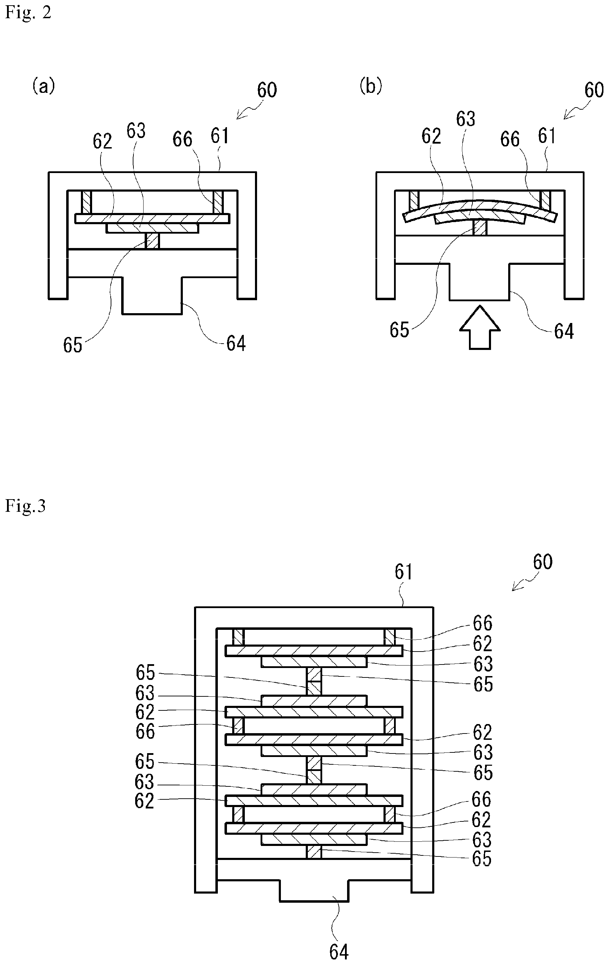

Figs. 2 are front diagrams illustrating a deformed state of the piezoelectric element 63 of the power generation module 60, in which Fig. 2(a) is a view illustrating a state before the piezoelectric element 63 is deformed, and Fig. 2(b) is a view illustrating a state after the piezoelectric element 63 is deformed. The power generation modules 60a to 60e convert the external force applied from the vehicle into electricity and comprise a cover portion 61, a diaphragm 62, the piezoelectric element 63, the pressing portion 64, a center spacer 65, and a peripheral spacer 66, respectively.

The cover portion 61 is a cover means for protecting the diaphragm 62, the piezoelectric element 63, the pressing portion 64, the center spacer 65, and the peripheral spacer 66. This cover portion 61 is a substantially box-shaped body with one side surface (a lower surface or the like, for example) open and is formed of a metal material or the like, for example. This cover portion 61 is disposed above an upper end of the first fluid chamber 10 and is fixed to a support portion, not shown, by a fixing tool or the like.

The diaphragm 62 is a support that applies a stress to the piezoelectric element 63 and also serves as a reinforcing material that reinforces crack strength of the piezoelectric element 63. This diaphragm 62 is formed of a disk-shaped body made of a steel material or the like having flexibility and durability such as a stainless thin plate or the like.

The piezoelectric element 63 is an element that generates electricity by deformation by a pressure. This piezoelectric element 63 is a thin-plate shaped body and is formed of a piezoelectric ceramics such as barium titanate, zirconia and the like, a piezoelectric single crystal such as lithium tantalate (LiTaO3) and the like. This piezoelectric element 63 is disposed so as to abut on a lower surface of the diaphragm 62 and is joined to the diaphragm 62 by an adhesive or the like. Moreover, in this piezoelectric element 63, an output terminal (specifically, a positive terminal and a negative terminal) for outputting the power generated by the piezoelectric element 63 to an outside is provided (each of these parts is not shown). As the piezoelectric element 63 or instead of the piezoelectric element 63, an arbitrary material that can generate power by an external force (including a force causing distortion, bending or compression) can be used, and an ionic polymer-metal composite (IPMC) obtained by plating metal (gold or the like) on both surfaces of a film (gel) of an ionic conductive polymer, an ionic conducting polymergel film (ICPF) or an artificial muscle using the IPMC or ICPF can be used, for example.

The pressing portion 64 is a pressing means pressed by the corresponding first piston 40. This pressing portion 64 is an inverted convex body formed of a metal material or the like, for example, and is disposed at a position where it can abut on the corresponding first piston 40.

The center spacer 65 is for forming an interval between the pressing portion 64 and the piezoelectric element 63 as well as the diaphragm 62 and also serves to transmit the force pressed by the corresponding first piston 40 to the piezoelectric element 63 and the diaphragm 62 through the pressing portion 64. This center spacer 65 is formed of a substantially columnar body or the like and is disposed so as to abut on the pressing portion 64 and the piezoelectric element 63 substantially at a center position on the upper surface of the piezoelectric element 63 and is fixed to the pressing portion 64 and the piezoelectric element 63 by an adhesive or the like.

The peripheral spacer 66 is to form an interval between the upper surface of the cover portion 61 and the piezoelectric element 63 as well as the diaphragm 62. This peripheral spacer 66 is formed having a substantially annular body and is located more outside than the piezoelectric element 63 fixed to the diaphragm 62, disposed so as to abut on a position close to an outer edge of the diaphragm 62, and is fixed to the diaphragm 62 and the cover portion 61 by an adhesive or the like.

Functions of the power generation module 60 configured as above are as follows. That is, when the pressing portion 64 is pressed by the first piston 40, the first piston 40 moves upward and can press/deform the piezoelectric element 63 with movement of the first piston 40 and thus, power generation is made possible.

The specific configuration of this power generation module 60 is arbitrary, and configurations illustrated below or the like may be employed other than the configuration of the aforementioned power generation module 60, for example. Fig. 3 is a diagram illustrating a variation of the power generation module 60. In the power generation module 60 illustrated in Fig. 3, specifically, five diaphragms 62 are juxtaposed substantially along the up-down direction at an interval from each other between the pressing portion 64 and the upper surface of the cover portion 61. On each of these diaphragms 62, the piezoelectric element 63 is disposed at a position where it can be pressed/deformed if it is pressed by the first piston 40 and is joined to the corresponding diaphragm 62. Moreover, between the pressing portion 64 and the first diaphragm 62 from the bottom, between adjacent diaphragms 62 among the first to fifth diaphragms 62 from the bottom, and between the fifth diaphragm 62 and the upper surface of the cover portion 61, the center spacer 65 or the peripheral spacer 66 is sequentially disposed alternately so that the piezoelectric element 63 can be deformed in the up-down direction (specifically, the center spacer 65 is disposed between the pressing portion 64 and the first diaphragm 62 from the bottom, and the peripheral spacer 66 is disposed between the first diaphragm 62 from the bottom and the second diaphragm 62 from the bottom and the like). By means of the configuration as above, the number of installed piezoelectric elements 63 can be increased, and thus, the power generation amount can be increased.

### (Functions of power generation system)

Functions of the power generation system 1 configured as above are as follows.

First, if the second piston 50 receives an external force from the vehicle, the force received by this second piston 50 is transmitted to the fluid contained in the second fluid chamber 20. Subsequently, the force transmitted to the fluid contained in the second fluid chamber 20 is transmitted to the fluid contained in the first fluid chambers 10a to 10e through the communication flow channel 30, and the transmitted force is transmitted to the corresponding first piston 40. Subsequently, the force received by each of the first pistons 40a to 40e is transmitted to the piezoelectric element 63 through the pressing portion 64 and the center spacer 65 of the corresponding power generation module 60. In this case, since the piezoelectric elements 63 of the power generation modules 60a to 60e are pressed by this transmitted force, respectively, these piezoelectric elements 63 can be pressed/deformed and thus, power generation is made possible. The power obtained by this power generation system 1 can be used for an arbitrary purpose (a power supply for a lighting device installed on the road, for example).

Particularly, even if the first fluid chambers 10a to 10e and the second fluid chamber 20 are installed separately from each other, the force received by the second piston 50 can be transmitted to the first pistons 40a to 40e via the fluid. Thus, even if it is difficult to ensure a space for installing the first fluid chambers 10a to 10e beside the road, for example, since the first fluid chambers 10a to 10e can be installed at positions far from the road, the degree of freedom of installation can be improved as compared with the conventional system.

### (Effect)

As described above, according to the embodiment 1, the piezoelectric elements 63 of the power generation modules 60a to 60e generate power in the cases where the second piston 50 provided in the second fluid chamber 20 is pressed, and the pressing force is transmitted to the first pistons 40 provided in the first fluid chambers 10a to 10e via the fluid, then the piezoelectric element 63 is pressed due to the force thus transmitted and thus, even if the first piston 40 and the second piston 50 are installed separately from each other, the force can be transmitted to the power generation modules 60a to 60e, and the degree of freedom of installation can be improved as compared with the conventional system. Particularly, since the first pistons 40 are disposed such that the fluid in the first fluid chambers 10a to 10e can be pressed, while the second piston 50 is disposed such that the fluid in the second fluid chamber 20 can be pressed, even if the first fluid chambers 10a to 10e and the second fluid chamber 20 are installed separately from each other, the force can be transmitted to the power generation modules 60a to 60e and thus, the degree of freedom of installation can be further improved.

Moreover, since the total area of the side surface of the second piston 50 that presses the fluid is set larger than the total area of the side surfaces of the first pistons 40a to 40e that press the fluid, the stroke of each of the first pistons 40a to 40e can be set to a length required for pressing the piezoelectric element 63 of the power generation module 60, while the stroke of the second piston 50 is set to such a length that does not interfere with running of the vehicle and thus, running performances of the vehicle and power generation efficiency can be maintained. Moreover, since the plurality of the first pistons 40 are dispersively arranged, a cost increase involved in a size increase of the shape of the piezoelectric element 63 of the power generation module 60 can be avoided as compared with the case of the arrangement of the single first piston 40, and cost reduction can be made by using the piezoelectric element 63 with a relatively small shape distributed in the market.

Moreover, the piezoelectric element 63 in each of the power generation modules 60a to 60e generates power in the cases where the second piston 50 is pressed, and the pressing force is transmitted to each of the plurality of the first pistons 40a to 40e via the fluid, then the piezoelectric element 63 is directly or indirectly pressed due to the force thus transmitted and thus, the power generation amount can be increased by increasing the number of installed power generation modules 60.

### [Embodiment 2]

Subsequently, a power generation system according to an embodiment 2 will be described. This embodiment 2 is a mode comprising a plurality of the second fluid chambers and a plurality of the second pistons in addition to the embodiment 1. Components substantially similar to those in the embodiment 1 are given the same reference numerals or names as those used in the embodiment 1 as necessary and the explanation will be omitted.

### (Configuration)

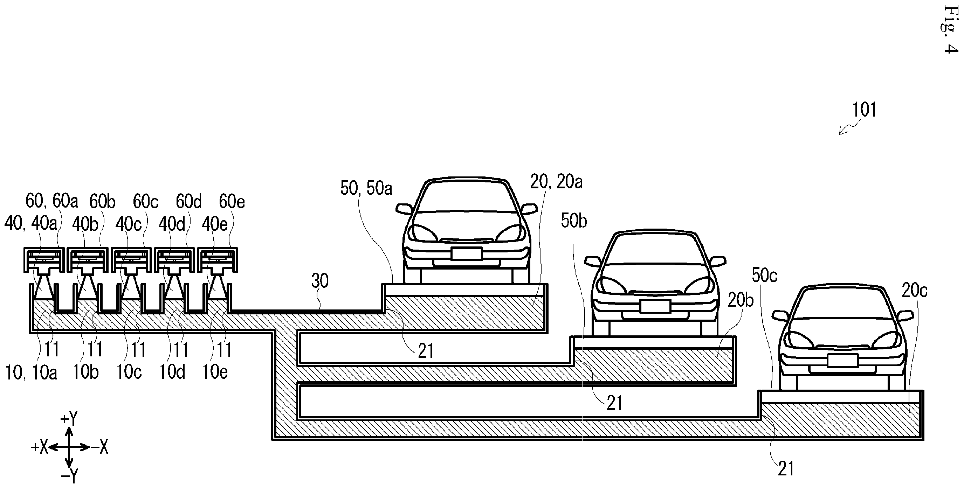

First, configuration of the power generation system according to the embodiment 2 will be described. Fig. 4 is a diagram illustrating an outline of the power generation system according to the embodiment 2. The power generation system 101 according to the embodiment 2 is configured by second fluid chambers 20a to 20c (if these second fluid chambers 20a to 20c do not have to be discriminated from each other, they are collectively referred to as the "second fluid chamber 20") instead of the second fluid chamber 20 and second pistons 50a to 50c (if these second pistons 50a to 50c do not have to be discriminated from each other, they are collectively referred to as the "second piston 50") instead of the second piston 50 with respect to the same components as the components in the power generation system 1 according to the embodiment 1. The following improvements are made also for the configuration specification of the communication flow channel 30.

### (Configuration - Second fluid chamber and second piston)

The second fluid chambers 20a to 20c are disposed at a predetermined interval (approximately 1 m, for example) on the road surface of the road. In Fig. 4, for convenience of preparing the figure, the second fluid chambers 20a to 20c are drawn as if they are disposed on different planes but actually they are assumed to be disposed on the same plane. Moreover, the second pistons 50a to 50c are disposed such that the fluid contained in the corresponding second fluid chambers 20 can be pressed or specifically, they are disposed such that lower surfaces of the second pistons 50a to 50c are brought into contact with the fluid contained in the corresponding second fluid chambers 20. Here, regarding a relation between a planar shape of each of the first pistons 40a to 40e and a planar shape of each of the second pistons 50a to 50c, a total area of side surfaces of the second pistons 50a to 50c that press the fluid (specifically, a total area of the lower surfaces of the second pistons 50a to 50c) is set larger than a total area of side surfaces of the first pistons 40a to 40d that press the fluid (specifically, the total area of the lower surfaces of the first pistons 40a to 40d), for example, so that a cost reduction can be made while running performances of the vehicle and power generation efficiency are maintained as described above.

### (Configuration - Communication flow channel)

The communication flow channel 30 is connected to each of the first fluid chambers 10a to 10e through the first communication port 11 of each of the first fluid chambers 10a to 10e and is also connected to each of the second fluid chambers 20a to 20c through the second communication port 21 of each of the second fluid chambers 20a to 20c.

By means of the configuration as above, if at least one of the second pistons 50a to 50c receives an external force from the vehicle, the force received by at least one of the second pistons 50a to 50c can be transmitted to each of the first pistons 40a to 40e via the fluid, and the piezoelectric elements 63 of the power generation modules 60a to 60e can be pressed due to the force thus transmitted. Thus, the frequency of pressing the piezoelectric elements 63 of the power generation modules 60a to 60e can be increased as compared with the embodiment 1, and the power generation amount can be increased.

The specific configuration of this power generation module 60 is arbitrary, and when two or more of the second pistons 50a to 50c receive the external force from the vehicle at the same time, if pressed deformation of the piezoelectric elements 63 of the power generation modules 60a to 60e becomes excessive by the force transmitted to each of the first pistons 40a to 40e and there is a concern of breakage of the piezoelectric element 63, a deformation suppression portion (not shown) that suppresses pressed deformation of the piezoelectric element 63 may be provided in each of the power generation modules 60a to 60e.

### (Functions of power generation system)

Functions of the power generation system 101 configured as above are as follows.

First, if each of the second pistons 50a to 50c receives the external force from the vehicle at the same time, the force received by these second pistons 50a to 50c is transmitted to the fluid contained in the corresponding second fluid chamber 20. Subsequently, the force transmitted to the fluid contained in the second fluid chambers 20a to 20c is transmitted to the fluid contained in the first fluid chambers 10a to 10e through the communication flow channel 30, and the transmitted force is transmitted to the corresponding first piston 40. Then, the force received by each of the first pistons 40a to 40e is transmitted to the piezoelectric element 63 through the pressing portion 64 and the center spacer 65 of the corresponding power generation module 60. In this case, since pressing on the piezoelectric elements 63 of the power generation modules 60a to 60e by this transmitted force can press/deform these piezoelectric elements 63, power generation is made possible.

### (Effect)

According to the embodiment 2 as above, the piezoelectric elements 63 in the power generation modules 60a to 60e generate power in the cases where at least a part of the second pistons 50a to 50c is pressed, and the pressing force is transmitted to the first pistons 40a to 40e via the fluid, then the piezoelectric elements 63 are directly or indirectly pressed due to the force thus transmitted and thus, if the second pistons 50a to 50c receive the external force from the running vehicle, for example, the frequency of pressing the piezoelectric elements 63 of the power generation modules 60a to 60e can be increased as compared with the case where the second piston 50 and the second fluid chamber 20 are singular, respectively, and the power generation amount can be increased.

### [Embodiment 3]

Subsequently, a power generation system according to an embodiment 3 will be described. This embodiment 3 is a mode different from the embodiment 2 and is a mode comprising a plurality of the second fluid chambers and a plurality of the second pistons in addition to the embodiment 1. Components substantially similar to those in the embodiment 1 are given the same reference numerals or names as those used in the embodiment 1 as necessary and the explanation will be omitted.

### (Configuration)

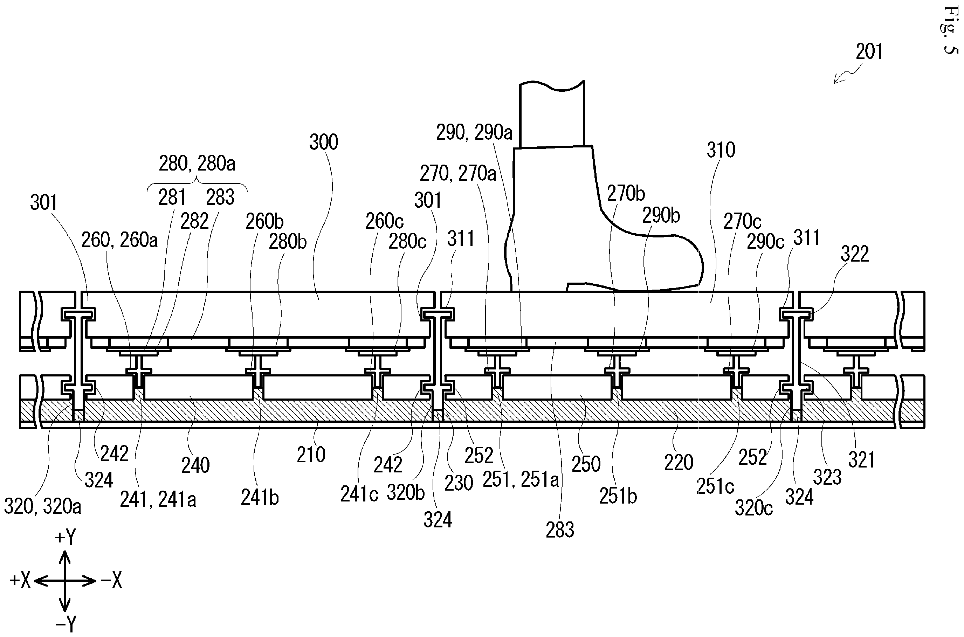

First, configuration of the power generation system according to the embodiment 3 will be described. Fig. 5 is a diagram illustrating an outline of the power generation system according to the embodiment 3. The power generation system 201 according to the embodiment 3 is a system that generates power by using an external force applied from a walking pedestrian. The power generation system 201 according to this embodiment 3 is configured by comprising a first main fluid chamber 210, a second main fluid chamber 220, a communication flow channel 230, a first main piston 240, a second main piston 250, first sub pistons 260a to 260c (when these first sub pistons 260a to 260c do not have to be discriminated from each other, they are collectively referred to as the "first sub piston 260"), second sub pistons 270a to 270c (when these second sub pistons 270a to 270c do not have to be discriminated from each other, they are collectively referred to as the "second sub piston 270"), first power generation modules 280a to 280c (when these first power generation modules 280a to 280c do not have to be discriminated from each other, they are collectively referred to as the "first power generation module 280"), second power generation modules 290a to 290c (when these second power generation modules 290a to 290c do not have to be discriminated from each other, they are collectively referred to as the "second power generation module 290"), a first upper surface material 300, a second upper surface material 310, and stoppers 320a to 320c (when these stoppers 320a to 320c do not have to be discriminated from each other, they are collectively referred to as the "stopper 320"). Here, Fig. 5 illustrates the aforementioned components of the power generation system 201 one each, but the actual power generation system 201 can be configured by comprising a plurality of the components. Thus, the components illustrated in Fig. 5 will be described below, while explanation of the other components will be omitted.

### (Configuration - First main fluid chamber, second main fluid chamber, and communication flow channel)

The first main fluid chamber 210 and the second main fluid chamber 220 are recess portions formed on the road surface of the road and are formed as sections of the recess portions in which the fluid (a liquid such as water, oil or the like or a semi-solid or solid such as polymer gel or the like) is stored, and they are disposed adjacent to each other. The communication flow channel 230 is disposed between the first main fluid chamber 210 and the second main fluid chamber 220.

### (Configuration - First main piston)

The first main piston 240 is a piston for pressing the first sub pistons 260a to 260c. This first main piston 240 is formed having a substantially columnar body and is formed of a metal material, a resin material with high hardness, a glass material with high hardness and the like, for example (the same is assumed to be applied to the second main piston 250). This first main piston 240 is disposed such that the fluid contained in the first main fluid chamber 210 can be pressed and specifically, it is disposed such that a lower surface of the first main piston 240 is brought into contact with the fluid contained in the first main fluid chamber 210.

In the first main piston 240, first sub fluid chambers 241a to 241c (when these first sub fluid chambers 241a to 241c do not have to be discriminated from each other, they are collectively referred to as the "first sub fluid chamber 241") are provided. The first sub fluid chambers 241a to 241c are formed by forming a through hole penetrating along the up-down direction in the first main piston 240 and are juxtaposed/disposed substantially along the left-right direction. The first main fluid chamber 210 and the first sub fluid chambers 241a to 241c correspond to a "first fluid chamber" in the claim.

### (Configuration - Second main piston)

The second main piston 250 is a piston that receives the pressing force from the second sub pistons 270a to 270c. This second main piston 250 is disposed such that the fluid contained in the second main fluid chamber 220 can be pressed and specifically, it is disposed such that a lower surface of the second main piston 250 is brought into contact with the fluid contained in the second main fluid chamber 220.

In the second main piston 250, second sub fluid chambers 251a to 251c (when these second sub fluid chambers 251a to 251c do not have to be discriminated from each other, they are collectively referred to as the "second sub fluid chamber 251") are provided. The second sub fluid chambers 251a to 251c are formed by forming a through hole penetrating along the up-down direction in the second main piston 250 and are juxtaposed/disposed substantially along the left-right direction. The second main fluid chamber 220 and the second sub fluid chambers 251a to 251c correspond to a "second fluid chamber" in the claim.

### (Configuration - First sub piston)

The first sub pistons 260a to 260c are pistons for pressing the corresponding first power generation modules 280. Each of these first sub pistons 260a to 260c is a columnar body having a substantially cross-shaped longitudinal section and is formed of a metal material, a resin material with high hardness, a glass material with high hardness and the like, for example (the same is assumed to be applied to the second sub pistons 270a to 270c). Each of these first sub pistons 260a to 260c is disposed such that the fluid contained in the corresponding first sub fluid chambers 241 can be pressed and specifically, they are disposed such that a lower surface of each of the first sub pistons 260a to 260c is brought into contact with the fluid contained in the corresponding first sub fluid chamber 241. The first main piston 240 and the first sub pistons 260a to 260c correspond to a "first piston" in the claim.

### (Configuration - Second sub piston)

The second sub pistons 270a to 270c are pistons that receive the pressing force from the corresponding second power generation modules 290. Each of these second sub pistons 270a to 270c is disposed such that the fluid contained in the corresponding second sub fluid chambers 251 can be pressed and specifically, they are disposed such that a lower surface of each of the second sub pistons 270a to 270c is brought into contact with the fluid contained in the corresponding second sub fluid chamber 251. The second main piston 250 and the second sub pistons 270a to 270c correspond to a "second piston" in the claim.

### (Configuration - First power generation module and second power generation module)

The first power generation modules 280a to 280c and the second power generation modules 290a to 290c convert the external force applied from the pedestrian into electricity and comprise a diaphragm 281, a piezoelectric element 282, and a spacer 283, respectively.

The piezoelectric element 282 is disposed so as to abut on a lower surface of the diaphragm 281 and is joined to the diaphragm 281 by an adhesive or the like.

The spacer 283 is to form an interval between the first upper surfaced material 300 (or the second upper surface material 310) and the piezoelectric element 282 as well as the diaphragm 281. This spacer 283 is formed having a substantially annular body and is located more outside than the piezoelectric element 282 fixed to the diaphragm 281, disposed so as to abut on a position close to an outer edge of the diaphragm 281, and is fixed to the diaphragm 281 and the first upper surface material 300 (or the second upper surface material 310) by an adhesive or the like.

### (Configuration - First upper surface material)

The first upper surface material 300 is to substantially cover the first main fluid chamber 210, the first sub fluid chambers 241a to 241c, the first main piston 240, the first sub pistons 260a to 260c, and the first power generation modules 280a to 280c. This first upper surface material 300 is a substantially block body formed of a metal material or the like (the same is assumed to be applied to the second upper surface material 310), for example, and is disposed so as to abut on the spacers 283 of the first power generation modules 280a to 280c.

### (Configuration - Second upper surface material)

The second upper surface material 310 is to substantially cover the second main fluid chamber 220, the second sub fluid chambers 251a to 251c, the second main piston 250, the second sub pistons 270a to 270c, and the second power generation modules 290a to 290c and is disposed so as to abut on the spacers 283 of the second power generation modules 290a to 290c.

### (Configuration - Stopper)

The stoppers 320a and 320b are movement limiting means for limiting movement of the first upper surface material 300 and the first main piston 240, and the stoppers 320b and 320c are movement limiting means for limiting movement of the second upper surface material 310 and the second main piston 250. This stopper 320a is disposed on a left end of the first main fluid chamber 210, this stopper 320b is disposed between the first main fluid chamber 210 and the second main fluid chamber 220, and this stopper 320c is disposed on a right end of the second main fluid chamber 220. These stoppers 320a to 320c are formed of a metal material, a resin material or the like, for example, and each of them comprises a stopper body 321, a first projection portion 322, and a second projection portion 323, respectively. A forming method of this stopper 320 is arbitrary but it includes a method of forming the stopper body 321, the first projection portion 322, and the second projection portion 323 by integral molding, for example.

The stopper body 321 is a basic structural body of the stopper 320. This stopper body 321 is a substantially lengthy rod-shaped body and is erected/installed in the recess portion and is fixed to the recess portion by a fixing tool or the like. In a lower part of this stopper body 321, a through hole 324 is formed so that the fluid in the communication flow channel 230 can flow from one main fluid chamber to another main fluid chamber (from the second main fluid chamber 220 to the first main fluid chamber 210, for example).

The first projection portion 322 is for limiting movement of the first upper surface material 300 or the second upper surface material 310. This first projection portion 322 is disposed so as to project toward groove portions 301 formed on left-right ends of the first upper surface material 300 or groove portions 311 formed on left-right ends of the second upper surface material 310 on an upper end of the stopper body 321. Here, a length in the up-down direction of each of these groove portions 301 and 311 is set to a length that can deform the piezoelectric elements 282 of the first power generation modules 280a to 280c and the second power generation modules 290a to 290c so that a predetermined power generation amount is obtained, for example (the same is assumed to be applied to a length in the up-down direction of each of groove portions 242 and 252 formed in the first main piston 240 and the second main piston 250 which will be described later).

The second projection portion 323 is for limiting movement of the first main piston 240 or the second main piston 250. This second projection portion 323 is disposed so as to project toward the groove portions 242 formed on the left-right ends of the first main pistons 240 or the groove portion 252 formed on the left-right ends of the second main piston 250 in the vicinity of a lower end of the stopper body 321.

By means of the configuration as above, when the second upper surface material 310 receives the external force from the pedestrian, the piezoelectric elements 282 of the second power generation modules 290a to 290c can be pressed by the force received by the second upper surface material 310. Moreover, by transmitting the force received by this second upper surface material 310 to the first main piston 240 and the first sub pistons 260a to 260c via the fluid by the second main piston 250 and the second sub pistons 270a to 270c, the piezoelectric elements 282 of the first power generation modules 280a to 280c can be pressed due to the force thus transmitted, respectively. In this power generation system 201, in the cases where the first upper surface material 300 receives the external force from the pedestrian, it is assumed that a function of the first main piston 240 is switched to the function of the second main piston 250, and the functions of the first sub pistons 260a to 260c are switched to the functions of the second sub pistons 270a to 270c. That is, the first main piston 240 and the second main piston 250 have the respective functions, and the first sub pistons 260a to 260c and the second sub pistons 270a to 270c have the respective functions.

### (Functions of power generation system)

Functions of the power generation system 201 configured as above are as follows.

First, if the second upper surface material 310 receives the external force from the pedestrian, the force received by this second upper surface material 310 is transmitted to the second sub pistons 270a to 270c through the second power generation modules 290a to 290c, respectively. In this case, pressing on the piezoelectric elements 282 of the second power generation modules 290a to 290c by the force received by the second upper surface material 310 can press/deform these piezoelectric elements 282 and thus, power generation is made possible. Subsequently, the force received by the second sub pistons 270a to 270c is transmitted to the fluid contained in the corresponding second sub fluid chambers 251 (finally transmitted to the fluid contained in the second main fluid chamber 220) and also transmitted to the fluid contained in the second main fluid chamber 220 through the second main piston 250. Subsequently, the force transmitted to the fluid contained in the second main fluid chamber 220 is transmitted to the fluid contained in the first main fluid chamber 210 through the communication flow channel 230, and the transmitted force is transmitted to the second sub pistons 270a to 270c through the first main piston 240 and also transmitted to the fluid contained in the first sub fluid chambers 241a to 241c, respectively, and then, transmitted to the corresponding second sub piston 270. Then, the force received by the first sub pistons 260a to 260c is transmitted to the piezoelectric element 282 of the corresponding first power generation module 280. In this case, pressing on the piezoelectric elements 282 of the first power generation modules 280a to 280c by this transmitted force can press/deform these piezoelectric elements 282 and thus, power generation is made possible.

### (Effect)

As described above, according to the embodiment 3, the piezoelectric elements 282 in the first power generation modules 280a to 280c generate power in the cases where the second main piston 250 and the second sub pistons 270a to 270c are pressed, and the pressing force is transmitted to the first main piston 240 and the first sub pistons 260a to 260c via the fluid, then the piezoelectric elements 282 are directly or indirectly pressed due to the force thus transmitted and thus, by increasing the number of the installed first power generation modules 280, the power generation amount can be increased.

### [Embodiment 4]

First, a power generation system according to an embodiment 4 will be described. This embodiment 4 is a mode comprising a fluid containing means, a first piston, and a second piston. Components substantially similar to those in the embodiment 1 are given the same reference numerals or names as those used in the embodiment 1 as necessary and the explanation will be omitted.

### (Configuration)

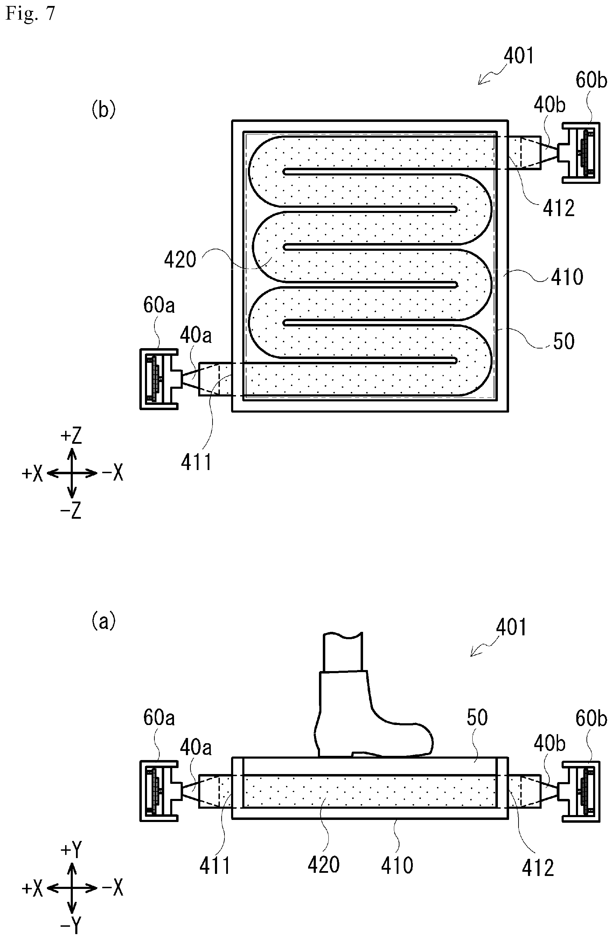

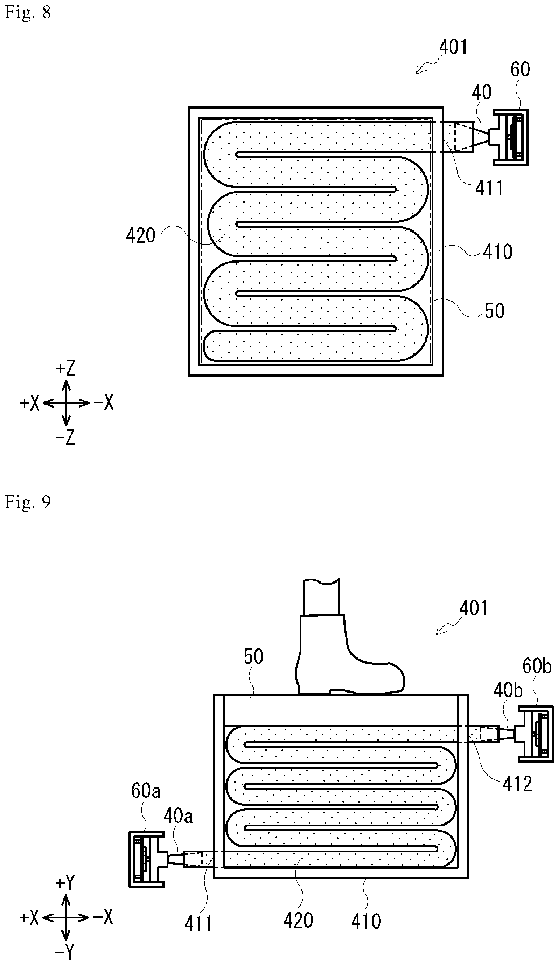

First, configuration of the power generation system according to the embodiment 4 will be described. Figs. 7 are diagrams illustrating an outline of the power generation system according to the embodiment 4, in which Fig. 7(a) is a front view and Fig. 7(b) is a plan view (In Fig. 7(b), the second piston 50 which will be described later is indicated by an imaginary line). Figs. 8 to 12 are diagrams illustrating variations of the power generation system according to the embodiment 4. The power generation system 401 according to the embodiment 4 is for generating power using an external force applied from a walking pedestrian. The power generation system 401 according to this embodiment 4 is configured by comprising a housing 410, a fluid containing portion 420, the first pistons 40a and 40b, the second piston 50, and the power generation modules 60a and 60b.

### (Configuration - Housing)

The housing 410 is a containing means that contains a part of the fluid containing portion 420 and at least a part of the second piston 50. This housing 410 is a substantially box-shaped body with one side surface (an upper surface, for example) open and is formed of a metal material, a resin material with high hardness, a glass material with high hardness and the like, for example.

On a left surface (or a right surface, a front surface, a rear surface or the like) of the housing 410, an opening 411 is provided, and on the right surface (or the left surface, the front surface, the rear surface or the like) of the housing 410, an opening 412 is provided. The opening 411 is an opening that exposes one of ends in a longitudinal direction in the fluid containing portion 420 to the outside from the housing 410. Moreover, the opening 412 is an opening that exposes the other end in the longitudinal direction in the fluid containing portion 420 to the outside from the housing 410.

### (Configuration - Fluid containing portion)

The fluid containing portion 420 is the fluid containing means that contains the fluid. This fluid containing portion 420 is configured by using a known lengthy hose having flexibility such as a rubber hose, a vinyl hose and the like, for example (specifically, both end surfaces in the longitudinal direction in the fluid containing portion 420 are open). Moreover, regarding installation of this fluid containing portion 420, specifically, a portion in the fluid containing portion 420 contained in the housing 410 is disposed in a state folded into bellows substantially along the front-rear direction (or the left-right direction) (in this case, generation of a gap between the fluid containing portion 420 and the housing 410 is allowed). Moreover, in a portion in the fluid containing portion 420 not contained in the housing 410, one of ends in the longitudinal direction in the fluid containing portion 420 is disposed so as to be exposed to the outside from the housing 410 through the opening 411, while the other end in the longitudinal direction in the fluid containing portion 420 is disposed so as to be exposed to the outside from the housing 410 through the opening 412. A portion close to the one end in the longitudinal direction in the fluid containing portion 420 and a portion close to the other end in the longitudinal direction are fixed to the housing 410 by a fixing tool or the like.

### (Configuration - First piston)

The first pistons 40a and 40b are disposed such that the fluid contained in the fluid containing portion 420 can be pressed. Specifically, the first piston 40a is disposed so as to be brought into contact with the fluid contained in the portion close to the one end in the longitudinal direction in the fluid containing portion 420, while the first piston 40b is disposed so as to be brought into contact with the fluid contained in the portion close to the other end in the longitudinal direction in the fluid containing portion 420.

### (Configuration - Second piston)

The second piston 50 is disposed such that the fluid contained in the fluid containing portion 420 can be pressed and specifically, it is disposed such that a lower surface of the second piston 50 is brought into contact with a portion in the fluid containing portion 420 contained in the housing 410.

### (Configuration - Power generation module)

The power generation modules 60a and 60b are to convert the external force applied from the pedestrian into electricity. Regarding arrangement of these power generation modules 60a and 60b, specifically, the power generation module 60a is disposed in the vicinity of the one ends in the longitudinal direction in the fluid containing portion 420 so that the pressing portion 64 of the power generation module 60a can abut on the first piston 40a. The power generation module 60b is disposed in the vicinity of the other end in the longitudinal direction in the fluid containing portion 420 so that the pressing portion 64 of the power generation module 60b can abut on the first piston 40b.

### (Functions of power generation system)

Functions of the power generation system 401 configured as above are as follows.

First, if the second piston 50 receives the external force from the pedestrian, the force received by the second piston 50 is transmitted to the fluid contained in the fluid containing portion 420. Subsequently, the force transmitted to the fluid contained in the fluid containing portion 420 is transmitted to the first pistons 40a and 40b. Then, the force received by each of 40a and 40b is transmitted to the piezoelectric element 63 through the pressing portion 64 and the center spacer 65 of the corresponding power generation module 60. In this case, pressing on the piezoelectric elements 63 of the power generation modules 60a and 60b by this transmitted force can press/deform these piezoelectric elements 63 and thus, power generation is made possible.

Other than the above, the power generation system 401 according to the embodiment 4 can be configured with an arbitrary structure. First, the embodiment 4 is described that both end surfaces in the longitudinal direction in the fluid containing portion 420 are open, but this is not limiting. For example, as illustrated in Fig. 8, either one of the both end surfaces in the longitudinal direction in the fluid containing portion 420 may be closed. In this case, the first piston 40 and the power generation module 60 are installed only at a position close to an end on the side where the end surface is open in the fluid containing portion 420.

Moreover, in the embodiment 4, it is described that the fluid containing portion 420 is disposed so that the portion in the fluid containing portion contained in the housing 410 is in the state folded into bellows substantially along the front-rear direction, but this is not limiting. For example, as illustrated in Fig. 9, the fluid containing portion 420 may be disposed so that the portion in the fluid containing portion 420 contained in the housing 410 is in the state folded by the bellows folding substantially along the up-down direction.

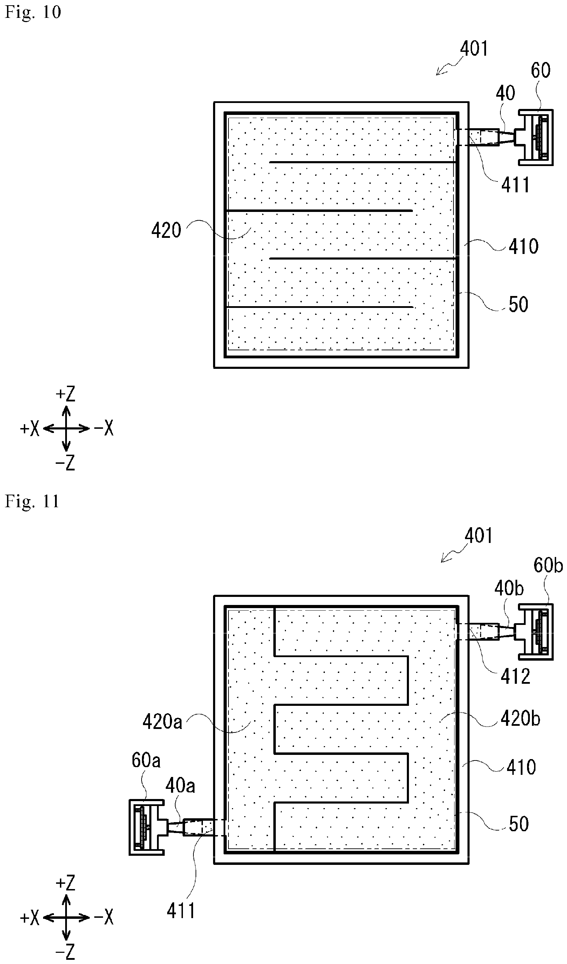

Moreover, in the embodiment 4, it is described that generation of a gap between the fluid containing portion 420 and the housing 410 is allowed, but this is not limiting, and for example, as illustrated in Figs. 10 to 12, the fluid containing portion 420 may be disposed in the housing 410 so that a gap is not generated between the fluid containing portion 420 and the housing 410.

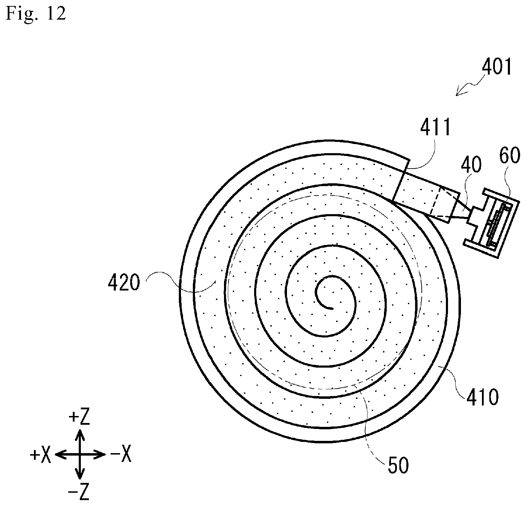

Specifically, as illustrated in Fig. 10, the one fluid containing portion 420 is disposed so that the portion in the one fluid containing portion 420 contained in the housing 410 is in the state folded into bellows substantially along the front-rear direction. Moreover, the sectional shape of this fluid containing portion 420 is formed specifically with a substantially rectangular shape (the same is assumed to be applied to the sectional shape of the fluid containing portion 420 illustrated in Figs. 11 and 12). By means of the configuration as above, when the second piston 50 receives an external force from the pedestrian, as illustrated in Fig. 8, as compared with the case where there is a gap between the fluid containing portion 420 and the housing 410 and the sectional shape of the fluid containing portion 420 is substantially circular, the fluid containing portion 420 is not deformed any more so as to fill the gap and thus, the force received by this second piston 50 can be efficiently transmitted to the fluid contained in the fluid containing portion 42.

Moreover, as illustrated in Fig. 11, fluid containing portions 420a and 420b formed each having a comb shape with a plurality of projection portions are formed, and the fluid containing portions 420a and 420b are disposed so that the projection portions of these fluid containing portions 420a and 420b are alternately fitted with each other.

Moreover, as illustrated in Fig. 12, if the housing 410 is formed having a substantially columnar shape, the one fluid containing portion 420 is disposed so that the portion in the one fluid containing portion 420 contained in the housing 410 has a spiral shape.

### (Effect)

As described above, according to the embodiment 4, the piezoelectric elements 63 of the power generation modules 60a and 60b generate power in the cases where the second piston 50 is pressed, and the pressing force is transmitted to the first pistons 40a and 40b via the fluid, then the piezoelectric elements 63 are directly or indirectly pressed due to the force thus transmitted and thus, even if the first pistons 40a and 40b are installed separately from the second piston 50, the force can be transmitted to the power generation modules 60a and 60b and thus, the degree of freedom of the installation can be further improved.

### [Variation of embodiments]

The embodiments according to the present invention have been described, but specific configuration and means of the present invention can be arbitrarily changed or improved within a range of the technical idea of each invention described in the claim. Such variations will be described below.

### (Problems to be solved and effects of the invention)

First, the problems to be solved or effects of the invention are not limited to the aforementioned contents, but the present invention can solve a problem not described in the above or can exert an effect not described in the above or solves only a part of the described problems or exerts only a part of the described effects in some cases. For example, even in the cases where the degree of freedom of installation becomes lower than the conventional system, if the means of the invention of the present application is different from the means of the conventional system, the problem of the present application is solved.

### (Shape, numerical value, structure, and time series)

Regarding the components exemplified in the embodiments and drawings, correlations among shapes, numerical values, structures of a plurality of the components or the time series can be arbitrarily modified or improved within the range of the technical idea of the present invention.

### (Power generation system)

In the aforementioned embodiments 1 and 2, it is described that the power generation system comprises a plurality of the first fluid chambers 10, a plurality of the first pistons 40, and a plurality of the power generation modules 60 but this is not limiting, and it may comprise the single first fluid chamber 10, the single first piston 40, and the single power generation module 60, for example.

Moreover, in the power generation system in the embodiments 1 and 2, it is described that power generation is performed by using the external force applied from the running vehicle, but power generation may be performed by using the external force applied from at least one or more tires (or a tire removed from the vehicle) in the stopped vehicle. As a result, since a pneumatic pressure of the tire can be measured on the basis of the power generation amount obtained by using this external force, the power generation system can be applied as a pneumatic pressure sensor of a tire.

### (Fluid)

In the aforementioned embodiments 1 to 3, it is described that the fluid is directly contained in the first fluid chamber, the second fluid chamber, and the communication flow channel, but this is not limiting. For example, in order to suppress drop of performances of the fluid (specifically, drop of durability of the fluid and the like), those containing the fluid in a bag body may be contained in the first fluid chamber, the second fluid chamber, and the communication flow channel.

### (Power generation module)

In the aforementioned embodiments 1 to 4, it is described that the power generation module is a power generation module (so-called a unimorph type) in which the piezoelectric elements are provided on either one of the side surfaces of the diaphragm but it may be a power generation module (so-called bimorph type) in which the piezoelectric elements are provided on both of the side surfaces of the diaphragm, for example.

Moreover, in the aforementioned embodiments 1 to 4, it is described that the power generation module comprises the diaphragm and the piezoelectric element, but in order to protect the piezoelectric element and the like, for example, it may further comprise a resin (piezo film or the like) for covering the whole or a part of the piezoelectric element. Alternatively, the diaphragm may be omitted, for example.

Moreover, in the aforementioned embodiments 1 to 4, it is described that the power generation module comprises the piezoelectric element, but instead of the piezoelectric element, a mechanism (specifically, an artificial muscle, a hydraulic motor, an electromagnetic induction-type motor, a super magnetostriction and the like) that can generate power by a reciprocating motion may be provided.

### (First fluid chamber and second fluid chamber)

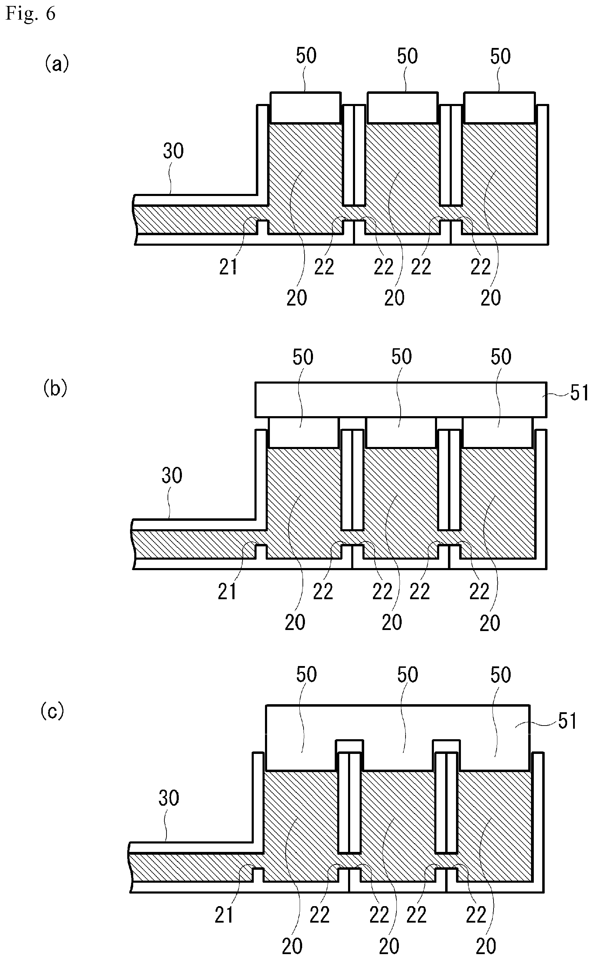

In the aforementioned embodiments 1 and 2, it is described that the second fluid chamber 20 is formed of a single substantially columnar hollow body, but this is not limiting. For example, as illustrated in Figs. 6(a) to 6(c), the second fluid chamber 20 may be configured by using a plurality of substantially box-shaped bodies each having one side surface(an upper surface, for example) open. Specifically, these plurality of the second fluid chambers 20 are juxtaposed substantially along the left-right direction (or may be juxtaposed substantially along the front-rear direction). Moreover, in each of these plurality of the second fluid chambers 20, a communication port 22 that makes communication with the adjacent box-shaped body possible is provided. The plurality of the second pistons 50 are disposed such that the fluid contained in each of the plurality of substantially box-shaped bodies can be pressed. In this case, a pressing plate 51 may be provided on upper surfaces of the plurality of the second pistons 50 as illustrated in Fig. 6(b), for example, so that the plurality of the second pistons 50 can be pressed at the same time. Alternatively, as illustrated in Fig. 6(c), the plurality of the second pistons 50 and the pressing plate 51 may be formed in an integral structure.

Moreover, the first piston 40 and the second piston 50 may be configured by changing structures, shapes, and materials. For example, by configuring each of the plurality of the second pistons 50 in Fig. 6(a) as a thin plate-shaped body disposed on an upper surface of a substantially box-shaped body containing the second pistons 50 so that the fluid contained in the substantially box-shaped body is pressed by curving of the thin plate-shaped body by the external force. Alternatively, in order to prevent easy removal or the like of the second piston 50 from the substantially box-shaped body containing the second piston 50, a fixing claw extending from the substantially box-shaped body may be locked by the upper surface of the second piston 50. Alternatively, the second piston 50 and the substantially box-shaped body containing the second piston 50 may be formed integrally. For example, the both may be formed of a resin and a portion corresponding to the second piston 50 may be made with such strength that can be pressed/deformed by a known method such as thinning so that the second piston 50 can be pressed/deformed.

### (Application target)

Moreover, the power generation system 1 can be applied to various facilities and devices. For example, by embedding the power generation system 1 in Fig. 6(a) in a road or a passage and by projecting only the second piston 50 to the road surface, the power generation system 1 can be configured to be used as a braille block for guiding a visually handicapped person, and in this case, by a pedestrian who steps on the second piston 50 by walking on the braille block, power can be generated. In this case, the braille block may be configured by providing a large number of the second pistons 50 as in Fig. 6(a) or the braille block may be configured by providing a series of the second pistons 50 as in Fig. 6(c) and then, by providing irregularity on the upper surface of this second piston 50. Alternatively, the power generation system 1 in Fig. 6(a) may be configured as an operating device such as a keyboard, a remote controller and the like, and in this case, a substantially box-shaped body containing the second piston 50 may be configured by a metal or a resin as a housing of the device and the second piston 50 may be configured as a push button such that it is projected from the housing and can be pressed. Particularly, it is suitably configured as a wireless keyboard, a remote controller, various switches, various buttons and the like that conduct communication using generated power.

### (Hose)

In the cases where the fluid containing chamber is configured by using a hose as in Figs. 7 to 12, by adjusting an interval of the hoses, a number of rounds, an installation position of a hose end, hardness of the hose, a filling degree of the fluid in the hose and the like as appropriate, a required pressing stroke or fluid stroke can be obtained. For example, by spacing the interval between the hoses so as to reduce the fluid stroke and to reduce the stroke applied to the piezoelectric element, a possibility that the piezoelectric element is pressed by an excessive stroke and broken or the like can be reduced. Regarding the installation position of the hose end, the both ends of the hose may be disposed on the same side surface of the housing or disposed on different arbitrary side surfaces or a plurality of the ends may be integrated into one end or the both ends of the same hose may be integrated into one end. Moreover, the hose is not limited to a hose having a cylindrical section, but an elastic body having a rectangular section such as a water pillow may be used. Alternatively, a plurality of the hoses may be disposed in a bent state or in a straight state inside a single housing.

### [Reference Numerals]

- 1,101,201,401: power generation system
- 10,10a-10e: first fluid chamber
- 11: first communication port
- 20,20a-20c: second fluid chamber
- 21: second communication port
- 22: communication port
- 30: communication flow channel
- 40,40a-40e: first piston
- 50,50a-50c: second piston
- 51: pressing plate
- 60,60a-60e: power generation module
- 61: cover portion
- 62: diaphragm
- 63: piezoelectric element
- 64: pressing portion
- 65: center spacer
- 66: peripheral spacer
- 210: first main fluid chamber
- 220: second main fluid chamber
- 230: communication flow channel
- 240: first main piston
- 241,241a-241c: first sub fluid chamber
- 242: groove portion
- 250: second main piston
- 251,251a-251c: second sub fluid chamber
- 252: groove portion
- 260,260a-260c: first sub piston
- 270,270a-270c: second sub piston
- 280,280a-280c: first power generation module
- 281: diaphragm
- 282: piezoelectric element
- 283: spacer
- 290,290a-290c: second power generation module
- 300: first upper surface material
- 301: groove portion
- 310: second upper surface material
- 311: groove portion
- 320,320a-320c: stopper
- 321: stopper body
- 322: first projection portion
- 323: second projection portion
- 324: through hole
- 410: housing
- 411: opening
- 412: opening
- 420,420a,420b: fluid containing portion
- D1-D3: flow channel diameter

## Claims

1. A power generation system comprising:
a fluid containing means that contains a fluid;
a first piston provided in the fluid containing means and disposed such that the fluid in the fluid containing means can be pressed;
a second piston provided in the fluid containing means and disposed such that the fluid in the fluid containing means can be pressed; and
a power generation module that converts a pressing force of the first piston into electricity using a power generation element; wherein
the power generation element of the power generation module generates power, in the cases where the second piston is pressed, and the pressing force is transmitted to the first piston via the fluid, then the power generation element is pressed directly or indirectly due to the force thus transmitted.

2. The power generation system according to claim 1, wherein
the fluid containing means has:
a first fluid chamber;
a second fluid chamber; and
a communication flow channel that causes the first fluid chamber and the second fluid chamber to communicate with each other, wherein
the first piston is disposed such that the fluid in the first fluid chamber can be pressed, and
the second piston is disposed such that the fluid in the second fluid chamber can be pressed.

3. The power generation system according to claim 1 or 2, wherein a total area of a side surface of the second piston that presses the fluid is set larger than the total area of a side surface of the first piston that presses the fluid.

4. The power generation system according to claim 2, wherein
the fluid containing means has:
a plurality of the first fluid chambers; and
the communication flow channel that causes each of the plurality of the first fluid chambers and the second fluid chamber to communicate with each other,
and comprises:
a plurality of the first pistons provided in each of the plurality of the first fluid chambers; and
a plurality of the power generation modules corresponding to each of the plurality of the first pistons, wherein
the power generation element in each of the plurality of power generation modules generates power in the cases where the second piston is pressed, and the pressing force is transmitted to each of the plurality of the first pistons via the fluid, then the power generation element is directly or indirectly pressed due to the force thus transmitted.

5. The power generation system according to claim 2, wherein
the fluid containing means has:
a plurality of the second fluid chambers; and
the communication flow channel that causes the first fluid chamber and each of the plurality of the second fluid chambers to communicate with each other,
and comprises a plurality of the second pistons provided in each of the plurality of the second fluid chambers, wherein
the power generation element in the power generation modules generates power in the cases where at least a part of the plurality of the second pistons is pressed, and the pressing force is transmitted to the first piston via the fluid, then the power generation element is directly or indirectly pressed due to the force thus transmitted.
